# DEMANDE DE BREVET EUROPEEN

(11) **EP 4 564 671 A1**
(43) Date de publication de la demande: **04.06.2025**
(21) Numéro de dépôt: 24216530.6
(22) Date de dépôt: 29.11.2024
(51) Int. Cl.: H03K 17/082, H01H 9/52, H01H 9/54, H01H 71/12, H01H 83/22, H02B 1/56, H02H 3/08, H05K 7/20

(54) **APPAREILLAGE DE PROTECTION A COUPURE ELECTRONIQUE AVEC DISSIPATEUR THERMIQUE**

(30) Priorité: 30.11.2023 FR 2313365
(71) Demandeur: Hager Next, 67210 Obernai (FR)
(72) Inventeur: GACEUS, Vincent, 67210 OBERNAI (FR); ZEISSLOFF, Thibaut, 67210 BERNARDSWILLER (FR)
(74) Mandataire: Cabinet Nuss

(57) **Abrégé**

L'invention concerne un appareillage de protection à coupure électronique comprenant: un boîtier (1), une ligne de courant de phase (P), une ligne de courant de neutre (N) entre une première borne de raccordement de neutre (4) et une deuxième borne de raccordement de neutre (5), une unité de coupure électronique (8) comprenant un composant électronique de coupure de puissance (9) disposé sur ladite ligne de courant de phase (P), un déclencheur électronique de protection, un dissipateur thermique (10) en matériau conducteur électrique, caractérisé en ce qu'il comprend :
- une portion conductrice de neutre (11) formant d'une part une première partie de la ligne de courant de neutre (N) et d'autre part dissipateur thermique (10) et étant raccordée électriquement entre la première borne de raccordement de neutre (4) et la deuxième borne de raccordement de neutre (5),
- la portion conductrice de neutre (11) étant d'une part disposée relativement à ladite unité de coupure électronique (8) de sorte à dissiper la chaleur provenant dudit composant électronique de coupure de puissance (9) associé à ladite ligne de courant de phase (P) au moins par conduction thermique et étant d'autre part isolée électriquement de ladite unité de coupure électronique (8).

## Description

L'invention concerne le domaine des appareillages de protection à coupure électronique avec un dissipateur thermique.

Des appareillages de protection à coupure électronique avec un dissipateur thermique sont connus par exemple de la publication WO2022106527A1 ou de la publication WO22243456 A1. Dans ces documents, il est notamment question de trouver une solution permettant d'évacuer efficacement la chaleur dégagée par les composants électroniques de coupure de puissance, de type transistor de puissance.

Plus particulièrement dans le document WO2022106527A1, il est proposé de disposer ladite unité de coupure électronique dans le boîtier en regard de la face latérale arrière en matériau métallique et qui comprend préférentiellement un dissipateur thermique par exemple avec une pluralité d'ailettes. Cette configuration permet d'optimiser la dissipation des pertes joules, d'optimiser la conduction thermique entre les composants électroniques de coupure de puissance avec un rail DIN, et d'optimiser la convection thermique avec l'air ambiant. Toutefois, cette solution nécessite de modifier la matière de la face latérale arrière du boîtier qui est habituellement en plastique et donc à un impact sur la matière du boîtier.

Plus particulièrement dans le document WO22243456A1, il est proposé de loger le bloc de coupure comportant les interrupteurs de puissance d'une ligne de phase entre plusieurs plaques conductrices et les parois du boîtier de l'appareil, ce qui a pour avantage de permettre la dissipation de l'énergie thermique et donc de réduire le nombre de composants de coupure à semi-conducteurs. Ce document divulgue en outre que l'énergie thermique dégagée par les interrupteurs est ici dissipée vers l'extérieur de l'appareil par conduction le long des conducteurs électriques de phase. Par exemple, l'énergie thermique est principalement dissipée par conduction et par rayonnement par les pièces conductrices vers l'extérieur de l'appareil. Pour la dissipation de l'énergie thermique par conduction, l'ensemble de la chaîne de passage du courant de phase à l'intérieur du disjoncteur est concerné, c'est-à-dire l'ensemble des conducteurs électriques, câbles d'alimentation électrique et lignes de conduction électrique qui permettent la circulation du courant de phase de l'amont vers l'aval de l'appareil. Toutefois, dans cette solution les câbles d'alimentation électrique ou tresses électriques utilisés sur les lignes de conduction électrique de phase ne présentent pas des propriétés de conduction thermique optimale et impliquent de plus des opérations d'assemblage fastidieuses et minutieuses avec notamment les plaques conductrices. En outre, cette solution nécessite d'effectuer des modifications conséquentes sur la ligne de courant de phase pour permettre de dissiper la chaleur provenant des interrupteurs de phase associés à la ligne de courant de phase à l'aide des plaques conductrices.

La présente invention a pour but de pallier au moins l'un de ces inconvénients et vise à proposer une solution alternative à l'art antérieur connu ayant un impact limité sur la matière du boîtier et sur la ligne de courant de phase.

A cet effet, l'invention concerne un appareillage de protection à coupure électronique comprenant au moins :
- un boîtier,
- une ligne de courant de phase entre une première borne de raccordement de phase et une deuxième borne de raccordement de phase,
- une ligne de courant de neutre entre une première borne de raccordement de neutre et une deuxième borne de raccordement de neutre,
- une unité de coupure électronique comprenant au moins un composant électronique de coupure de puissance disposé sur ladite ligne de courant de phase,
- un déclencheur électronique de protection comprenant au moins une unité de commande couplée à ladite unité de coupure électronique configuré pour piloter l'ouverture dudit au moins un composant électronique de coupure de puissance en cas d'apparition d'un défaut,
- au moins un dissipateur thermique en matériau conducteur électrique,

l'appareillage de protection à coupure électronique est caractérisé en ce qu'il comprend :
- une portion conductrice de neutre formant d'une part au moins une première partie de la ligne de courant de neutre et d'autre part dissipateur thermique et étant raccordée électriquement entre la première borne de raccordement de neutre et la deuxième borne de raccordement de neutre,
- la portion conductrice de neutre étant d'une part disposée relativement à ladite unité de coupure électronique de sorte à dissiper la chaleur provenant dudit au moins un composant électronique de coupure de puissance associé à ladite ligne de courant de phase au moins par conduction thermique et étant d'autre part isolée électriquement de ladite unité de coupure électronique.

L'invention sera mieux comprise, grâce à la description ci-après, qui se rapporte à plusieurs modes de réalisation préférés, donnés à titre d'exemple non limitatifs, et expliqués avec référence aux dessins schématiques annexés, dans lesquels :
[Fig. 1] la figure 1 représente une vue en perspective et partielle d'un appareillage de protection à coupure électronique selon l'invention,
[Fig. 2] la figure 2 représente une vue en perspective, en éclaté et partielle de l'appareillage de protection à coupure électronique selon l'invention,
[Fig. 3] la figure 3 représente une vue de dessus d'une portion conductrice de phase et d'une portion conductrice de neutre interfacées thermiquement avec une unité de coupure électronique de l'appareillage de protection à coupure électronique selon l'invention,
[Fig. 4] la figure 4 représente une vue en perspective et en coupe de la portion conductrice de phase et de la portion conductrice de neutre séparées par une paroi séparatrice isolante et interfacées thermiquement avec l'unité de coupure électronique de l'appareillage de protection à coupure électronique selon l'invention, et
[Fig. 5] la figure 5 représente une vue en perspective, en coupe, partielle de l'appareillage de protection à coupure électronique selon l'invention.

L'invention concerne un appareillage de protection à coupure électronique comprenant au moins :
- un boîtier 1,
- une ligne de courant de phase P entre une première borne de raccordement de phase 2 et une deuxième borne de raccordement de phase 3,
- une ligne de courant de neutre N entre une première borne de raccordement de neutre 4 et une deuxième borne de raccordement de neutre 5,
- une unité de coupure électronique 8 comprenant au moins un composant électronique de coupure de puissance 9 disposé sur ladite ligne de courant de phase P,
- un déclencheur électronique de protection comprenant au moins une unité de commande couplée à ladite unité de coupure électronique 8 configuré pour piloter l'ouverture dudit au moins un composant électronique de coupure de puissance 9 en cas d'apparition d'un défaut,
- au moins un dissipateur thermique 10 en matériau conducteur électrique.

Conformément à l'invention, l'appareillage de protection à coupure électronique est caractérisé en ce qu'il comprend :
- une portion conductrice de neutre 11 formant d'une part au moins une première partie de la ligne de courant de neutre N et d'autre part dissipateur thermique 10 et étant raccordée électriquement entre la première borne de raccordement de neutre 4 et la deuxième borne de raccordement de neutre 5,
- la portion conductrice de neutre 11 étant d'une part disposée relativement à ladite unité de coupure électronique 8 de sorte à dissiper la chaleur provenant dudit au moins un composant électronique de coupure de puissance 9 associé à ladite ligne de courant de phase P au moins par conduction thermique et étant d'autre part isolée électriquement de ladite unité de coupure électronique 8.

Avantageusement, la portion conductrice de neutre 11 est interfacée thermiquement avec l'unité de coupure électronique 8 comprenant ledit au moins un composant électronique de coupure de puissance 9 de la ligne de courant de phase P en étant isolée électriquement de celle-ci. Grâce à cette configuration, on utilise non pas la ligne de courant de phase P pour dissiper la chaleur émanant dudit au moins un composant électronique de coupure de puissance 9 de la ligne de courant de phase P, mais de manière contre intuitive au moins une partie de la ligne de courant de neutre N qui forme un dissipateur thermique 10 et permet d'évacuer la chaleur vers la première borne de raccordement de neutre 4.

On notera que dans le cas du courant continu, la portion conductrice de neutre 11 peut permettre la circulation du courant électrique dans le sens allant de la deuxième borne de raccordement de neutre 5 vers la première borne de raccordement de neutre 4 ou dans le sens allant de la première borne de raccordement de neutre 4 vers la deuxième borne de raccordement de neutre 5.

On notera également que la portion conductrice de neutre 11 permet d'évacuer la chaleur provenant dudit au moins un composant électronique de coupure de puissance 9 vers la première borne de raccordement de neutre 4 par conduction thermique.

De préférence, la portion conductrice de neutre 11 est isolée électriquement de ladite unité de coupure électronique 8 par un élément isolant électrique et conducteur thermique 13.

Avantageusement, l'élément isolant électrique et conducteur thermique 13 permet d'une part d'isoler électriquement la portion conductrice de neutre 11 de l'unité de coupure électronique 8 afin de respecter les distances diélectriques et éviter les claquages et d'autre part de favoriser la conduction de la chaleur provenant dudit composant électronique de coupure de puissance 9 de la ligne de courant de phase P vers la ligne de courant de neutre N.

De préférence, l'appareillage de protection à coupure électronique comprend au moins un compartiment de phase 14 comprenant au moins la première borne de raccordement de phase 2, la deuxième borne de raccordement de phase 3 et ladite unité de coupure électronique 8, et un compartiment de neutre 15 comprenant au moins la première borne de raccordement de neutre 4 associée à la portion conductrice de neutre 11 et la deuxième borne de raccordement de neutre 5, le compartiment de phase 14 et le compartiment de neutre 15 étant séparés par une paroi séparatrice isolante 16 comprenant un passage 17 configuré pour permettre la conduction thermique de ladite unité de coupure électronique 8 vers la portion conductrice de neutre 11.

La création dans le boîtier 1 du compartiment de phase 14 et du compartiment de neutre 15 permet de diviser le boîtier 1 au moins en deux parties et de séparer physiquement ladite au moins une ligne de courant de phase P de la ligne de courant de neutre N pour respecter l'isolement diélectrique entre le potentiel de phase et le potentiel de neutre. Dans le cas d'un appareillage de protection à coupure électronique multipolaire comprenant plusieurs lignes de courant de phase P et une ligne de neutre N, le boîtier 1 peut comprendre autant de compartiments de phase 14 que de lignes de courant de phase P. Le passage 17 permet encore d'améliorer la conduction thermique en fournissant un accès direct entre le compartiment de phase 14 et le compartiment de neutre 15 et ainsi en limitant le nombre d'interfaces entre la portion conductrice de neutre 11 et l'unité de coupure électronique 8.

De préférence, ladite unité de coupure électronique 8 comprend au moins une carte électronique 18 comprenant une première face 19 et une deuxième face 20 opposée à la première face 19 et ladite unité de coupure électronique 8 comprend un premier ensemble E1 d'au moins un composant électronique de coupure de puissance 9 sur ladite ligne de courant de phase P monté sur la première face 19 ou la deuxième face 20 et un deuxième ensemble E2 d'au moins un composant électronique de coupure de puissance 9 sur ladite ligne de courant de phase P monté sur la première face 19 ou la deuxième face 20 et relié électriquement en tête-bêche dudit au moins un composant électronique de coupure de puissance 9 du premier ensemble E1.

De préférence, la carte électronique 18 est parallèle à la paroi séparatrice isolante 16 et ledit au moins un composant électronique de coupure de puissance 9 du deuxième ensemble E2 est monté sur la première face 19 en regard du passage 17 et comprend un élément dissipateur (non représenté) orienté contre la première face 19 et une face isolée 21 orientée à l'opposé, la portion conductrice de neutre 11 comporte une interface de contact 22 qui est disposée en regard et à une distance de la face isolée 21.

Avantageusement, comme ledit au moins un composant électronique de coupure de puissance 9 du deuxième ensemble E2 est en regard de la portion conductrice de neutre 11 et donc aligné avec celle-ci, on optimise la conduction thermique tout en respectant la distance d'isolement diélectrique. Dans cet exemple, l'évacuation de la chaleur provenant des composants électroniques de coupure de puissance 9 du deuxième ensemble E2 est réalisée par conduction thermique notamment en outre dans la portion conductrice de neutre 11 vers la première borne de raccordement de neutre 4. Une partie des calories est également évacuée vers la deuxième borne de raccordement de neutre 5 et le cas échéant vers le deuxième ensemble de contacts. De manière alternative et avantageuse, il pourrait être prévu selon une variante non représentée que la face isolée dudit au moins un composant électronique de coupure de puissance 9 du deuxième ensemble E2 soit orientée contre la première face 19 et l'élément dissipateur soit orienté à l'opposé et que donc l'interface de contact 22 soit disposée en regard et à une distance de l' élément dissipateur.

De préférence, l'élément isolant électrique et conducteur thermique 13 est intercalé entre la face isolée 21 et l'interface de contact 22 et est disposé à la fois contre la face isolée 21 et l'interface de contact 22.

Avantageusement, l'élément isolant électrique et conducteur thermique 13 permet de maintenir physiquement la distance d'isolement diélectrique entre la face isolée 21 dudit au moins un composant électronique de coupure de puissance 9 du deuxième ensemble E2 et l'interface de contact 22 de la portion conductrice de neutre 11 tout en permettant la conduction thermique. De manière alternative et avantageuse, l'élément isolant électrique et le conducteur thermique 13 pourraient selon la variante non représentée décrite précédemment permettre de maintenir physiquement la distance d'isolement diélectrique entre l'élément dissipateur dudit au moins un composant électronique de coupure de puissance 9 du deuxième ensemble E2 et l'interface de contact 22 de la portion conductrice de neutre 11 tout en permettant la conduction thermique.

De préférence, la première/deuxième borne de raccordement de neutre 4, 5 comprend une pièce conductrice 6 comprenant au moins une portion de contact 7 configurée pour venir au contact avec un conducteur d'alimentation du réseau ou d'une charge, la pièce conductrice 6 de la première borne de raccordement de neutre 4 est prolongée par la portion conductrice de neutre 11, la pièce conductrice 6 et la portion conductrice de neutre 11 formant une pièce conductrice monobloc 12.

Avantageusement, la pièce conductrice 6 de la première/deuxième borne de raccordement de neutre 4, 5 intègre une portion conductrice de neutre 11 qui est interfacée thermiquement avec l'unité de coupure électronique 8 comprenant ledit au moins un composant électronique de coupure de puissance 9 de la ligne de courant de phase P en étant isolée électriquement de celle-ci. Aucun raccordement au moyen de câble électrique ou tresse électrique n'est utilisé pour raccorder la première/deuxième borne de raccordement de neutre 4, 5 au dissipateur thermique 10 formé par la portion conductrice de neutre 11. La pièce conductrice 6 et la portion conductrice de neutre 11 se présentent sous la forme d'une pièce conductrice monobloc 12. Il en résulte une réduction du nombre de pièces et une amélioration des opérations d'assemblage de l'appareillage de protection à coupure électronique et une dissipation de la chaleur par conduction thermique le long de la ligne de courant de phase N.

Préférentiellement, la pièce conductrice monobloc 12 est réalisée en métal et de préférence en cuivre.

De préférence, l'appareillage de protection à coupure électronique comprend en outre un mécanisme d'isolation galvanique comprenant un premier ensemble de contacts avec un premier contact fixe 23 et un premier contact mobile disposés sur la ligne de courant de phase P en série avec ladite au moins un composant électronique de coupure de puissance 9 et un deuxième ensemble de contacts avec un deuxième contact fixe 24 et un deuxième contact mobile disposés sur la ligne de courant de neutre N en amont ou en aval de la portion conductrice de neutre 11.

Le mécanisme d'isolation galvanique permet d'isoler l'appareillage de protection à coupure électronique notamment après l'ouverture dudit au moins un composant électronique de coupure de puissance 9 consécutivement à l'apparition d'un défaut, en interrompant la circulation du courant sur la ligne de courant de phase P et la ligne de courant de neutre N.

De préférence, la ligne de courant de neutre N est dépourvue de composants électroniques de coupure de puissance.

Dans cette configuration avantageuse, la ligne de courant de neutre N ne peut pas être interrompue par le déclencheur électronique de protection et l'unité de coupure électronique 8 lors de l'apparition d'un défaut. En revanche, la séparation du deuxième ensemble de contacts de la ligne de courant de neutre N peut être commandée par le déclencheur électronique de protection en cas d'apparition d'un défaut.

De préférence, ledit au moins un composant électronique de coupure de puissance 9 comprend au moins un transistor de puissance et préférentiellement au moins un MOSFET et/ou un JFET et/ou un IGBT.

Le boîtier 1 présente de préférence une forme globalement parallélépipédique avec une première face principale (non représentée) et une deuxième face principale (non représentée), et des faces latérales, respectivement arrière 25, supérieure 26, inférieure 27, avant (non représentée) s'étendant de l'une à l'autre des première et deuxième faces principales et avec une largeur, c'est-à-dire l'écart entre les première et deuxième faces principales, égale à un nombre entier de fois une distance prédéterminée, appelée module valant généralement environ 18 millimètres.

Grâce à cette disposition avantageuse, le format du boîtier 1 est modulaire et il en résulte un appareillage de protection à coupure électronique modulaire.

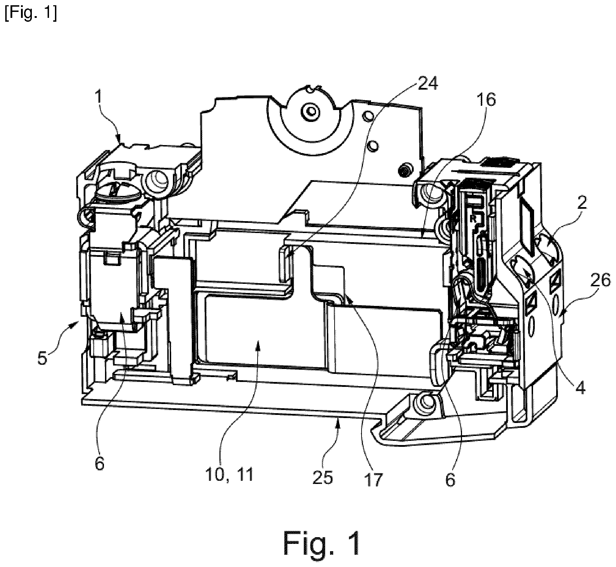

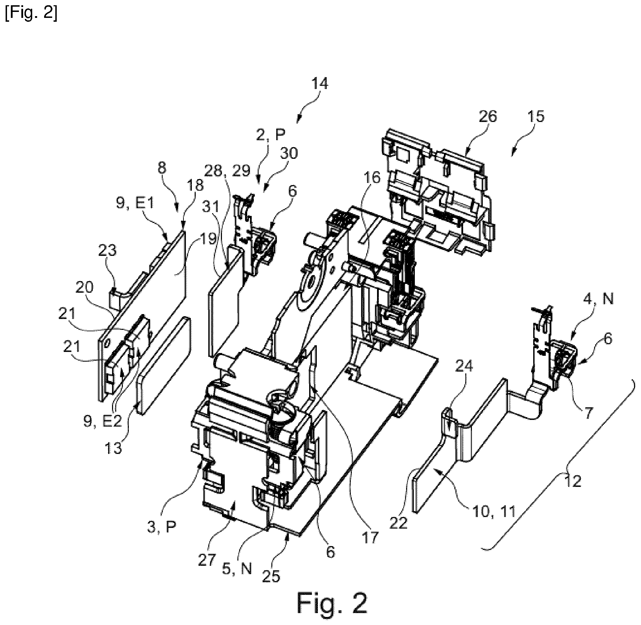

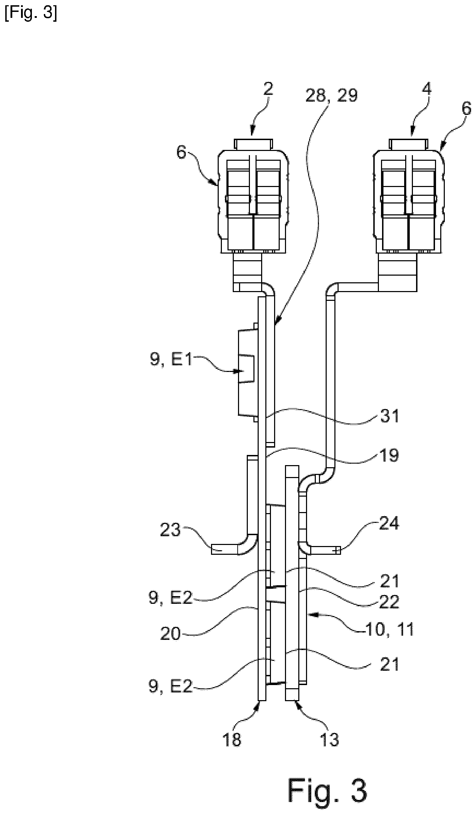

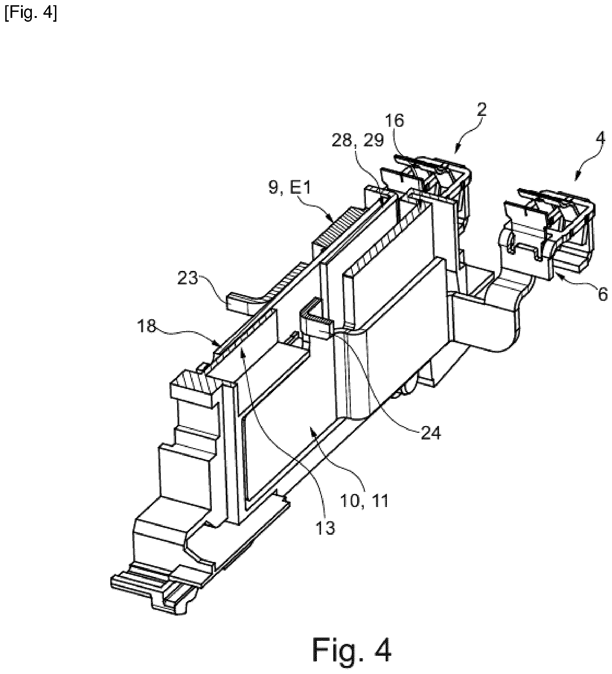

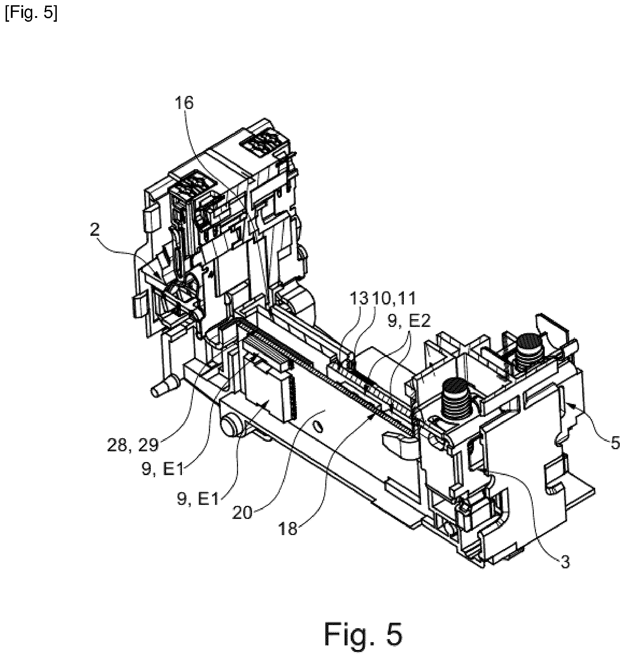

L'appareillage de protection à coupure électronique représenté aux figures 1à 5 présente une largeur de deux modules. Cet exemple n'est pas limitatif.

L'appareillage de protection à coupure électronique peut comprendre une ligne de courant de phase P, ou plusieurs lignes de courant de phase P, et dans tous les cas il comprend en outre une ligne de courant de neutre. Les figures 1 à 5 illustrent un appareillage de protection à coupure électronique avec une ligne de courant de phase P et une ligne de courant de neutre N.

L'appareillage de protection à coupure électronique peut être un disjoncteur ou réaliser une fonction de protection de disjoncteur différentiel, mais également d'autres fonctionnalités par exemple la mesure de courant et de la tension, la protection contre les défauts d'arcs électriques dans l'installation.

Lorsque l'appareillage de protection à coupure électronique réalise une fonction de protection de disjoncteur différentiel, il comprend de préférence un capteur de courant différentiel (non représenté) permettant de détecter des défauts de type défauts différentiels et qui est relié à l'unité de commande. Le capteur de courant différentiel est apte et destiné au moins à mesurer le courant différentiel circulant entre ladite au moins une ligne de courant de phase P et la ligne de courant de neutre N et à émettre un signal d'acquisition représentatif de l'image du courant différentiel entre la ligne de courant de phase P et la ligne de courant de neutre N. Le capteur de courant différentiel permet de détecter les défauts différentiels.

La première borne de raccordement de phase 2 et la première borne de raccordement de neutre 4 peuvent être une borne à cage à vis ou une borne de serrage automatique de type ressort ou similaire. Dans les exemples illustrés dans les figures la première borne de raccordement de phase 2 et la première borne de raccordement de neutre 4 sont chacune une borne à serrage automatique de type ressort et sont disposées à l'intérieur du boîtier 1 à proximité de la face latérale supérieure 26.

La deuxième borne de raccordement de phase 3 et la deuxième borne de raccordement de neutre 5 peuvent être une borne à cage à vis ou une borne serrage automatique de type ressort ou similaire et/ou mixte de type cage à serrage automatique et vis. Dans les exemples illustrés dans les figures la deuxième borne de raccordement de phase 3 et la deuxième borne de raccordement de neutre 5 sont chacune une borne mixte de type cage à serrage automatique et vis et sont disposées à l'intérieur du boîtier 1 à proximité de la face latérale inférieure 27.

Dans le cas d'une première borne de raccordement de phase 2 ou d'une première borne de raccordement de neutre 4 à serrage automatique illustrées dans les figures 1 à 5, les premières bornes de raccordement de phase 2 ou de neutre 4 comprennent chacune une pièce conductrice 6 comprenant au moins une portion de contact 7 configurée pour venir au contact avec un conducteur d'alimentation du réseau ou d'une charge. La pièce conductrice 6 comprend une pièce métallique élastiquement déformable qui permet de pincer au moins un conducteur d'alimentation du réseau ou d'une charge au niveau de la portion de contact 7. Dans les exemples illustrés dans les figures, cette pièce métallique élastiquement déformable comprend deux branches élastiques se rejoignant. Les deux pièces conductrices 6 sont disposées à l'intérieur du boîtier 1 à proximité de la face latérale supérieure 26.

L'unité de commande (non représentée) du déclencheur électronique de protection est reliée électriquement à l'unité de coupure électronique 8. L'unité de commande et l'unité de coupure électronique 8 sont disposées à l'intérieur du boîtier 1. Par exemple, l'unité de commande peut comprendre au moins un microcontrôleur et au moins un driver de puissance.

L'unité de commande et l'unité de coupure électronique 8 peuvent respectivement comprendre une ou plusieurs cartes électroniques. L'unité de commande et l'unité de coupure électronique 8 pourraient comprendre de manière alternative une unique carte électronique comprenant ledit microcontrôleur et ledit driver de puissance et ledit au moins un composant électronique de coupure de puissance 9. Dans l'exemple illustré dans les figures l'unité de coupure électronique 8 et l'unité de commande ne sont pas regroupées sur une même carte électronique, mais sur au moins deux cartes électroniques distinctes connectées électriquement et mécaniquement entre elles, seule la carte électronique 18 est représentée.

Dans ce cas, l'unité de coupure électronique 8 comporte la carte électronique 18 sur laquelle est monté et de préférence intégré ledit au moins un composant électronique de coupure de puissance 9. La carte électronique 18 est disposée dans le compartiment de phase 14 de préférence parallèlement aux première et deuxième faces principales du boîtier 1 et à la paroi séparatrice isolante 16 et s'étend dans le sens de la longueur dans un espace situé entre les première et deuxième bornes de raccordement de phase 2, 3, dans le sens de la largeur dans un espace situé entre la face latérale arrière 25 et la face latérale avant, et dans le sens de l'épaisseur dans un espace situé entre la deuxième face principale et la paroi séparatrice isolante 16. Dans l'exemple illustré dans les figures, la carte électronique 18 est préférentiellement disposée au moins en partie en regard de la deuxième face principale.

Le premier ensemble E1 de composant électronique de coupure de puissance 9 et le deuxième ensemble E2 de composant électronique de coupure de puissance 9 sont de préférence montés en série, par exemple de façon tête-bêche, sur la ligne de courant de phase P.

Dans l'exemple illustré, le premier ensemble E1 et le deuxième ensemble E2 comptent chacun deux composants électroniques de coupure de puissance 9. Cet exemple n'est pas limitatif. Le premier ensemble E1 comprend au moins deux composants électroniques de coupure de puissance 9 dans le même sens et montés en parallèle. Le deuxième ensemble E2 comprend au moins deux composants électroniques de coupure de puissance 9 dans le même sens et montés en parallèle.

L'élément dissipateur (non représenté) du composant électronique de coupure de puissance 9 est généralement en métal.

II peut être fixé sur un corps en céramique ou en plastique de préférence moulé du composant électronique de coupure de puissance 9.

Dans ce cas, l'élément dissipateur peut être sous la forme d'une plaque métallique, correspondant au drain du composant électronique de coupure de puissance 9, laquelle est disposée à l'opposé de la face isolée 21. Selon les types de composants électroniques de coupure de puissance 9, le drain peut en outre réaliser une fonction de connexion électrique avec un élément dissipateur rapporté décrit ci-après. Cela peut par exemple être le cas lorsque le drain est situé au niveau de la face du composant électronique de coupure de puissance 9, pouvant être la face supérieure, ne reposant pas contre une des faces 19, 20 de la carte électronique 18. Toutefois, lorsque le drain est situé sur la face du composant électronique de coupure de puissance 9, pouvant être la face inférieure, qui repose sur une des faces 19, 20 de la carte électronique 18, le drain ne réalise pas de fonction de connexion électrique avec un élément dissipateur rapporté.

De manière alternative, l'élément dissipateur peut être une pièce distincte et rapportée au composant électronique de coupure de puissance 9 et notamment ne correspondant pas au drain. L'élément dissipateur peut être dans ce cas sous la forme d'une pièce munie d'une pluralité d'ailettes. Soit cet élément dissipateur n'est pas en contact électrique avec le drain du composant électronique de coupure de puissance 9 et est monté sur la face isolée 21, soit cet élément dissipateur peut être en contact électrique avec le drain du composant électronique de coupure de puissance 9. Il en résulte que dans cette variante, le drain doit être situé au niveau de la face du composant électronique de coupure de puissance 9 ne reposant pas contre une des faces 19, 20 de la carte électronique 18.

La portion conductrice de neutre 11 formant un dissipateur thermique 10 peut se présenter de préférence sous la forme d'une pièce plane ou plaque plane avec ou sans une zone de pliage. De préférence, la pièce plane ou plaque plane est disposée dans le boîtier 1 parallèlement aux première et deuxième faces principales, à la paroi séparatrice isolante 16 et à la carte électronique 18 et dans le compartiment de neutre 15. La pièce plane ou plaque plane s'étend dans le sens de la longueur dans un espace situé entre les première et deuxième bornes de raccordement de neutre 4, 5, dans le sens de la largeur dans un espace situé entre la face latérale arrière 25 et la face latérale avant, et dans le sens de l'épaisseur dans un espace situé entre la première face principale et la paroi séparatrice isolante 16

La portion conductrice de neutre 11 se trouve dans le prolongement de la portion de contact 7 de la première borne de raccordement de neutre 4.

On entend par pièce conductrice monobloc 12 une pièce formée d'un seul tenant par exemple par pliage ou emboutissage par exemple d'une pièce conductrice de préférence métallique. Autrement dit, la portion de contact 7 de préférence conductrice et la portion conductrice de neutre 11 ne sont pas deux pièces distinctes et séparées, il n'existe pas de jonction par liaison mécanique entre deux pièces distinctes et qui serait formée entre la portion de contact 7 et la portion conductrice de neutre 11.

L'élément isolant électrique et conducteur thermique 13 comprend de préférence un matériau conducteur thermique et isolant électrique par exemple un polymère tel qu'un polyimide ou un matériau minéral non métallique tel que de la céramique. L'élément isolant électrique et conducteur thermique 13 peut se présenter sous la forme d'une plaque plane par exemple de forme sensiblement rectangulaire et qui recouvre le deuxième ensemble E2 de composant électronique de coupure de puissance 9. L'élément isolant électrique et conducteur thermique 13 est de préférence disposé dans le compartiment de phase 14.

La paroi séparatrice isolante 16 est de préférence dans un matériau polymère tel que du plastique.

Le passage 17 présente de préférence une forme sensiblement rectangulaire. Le passage 17 est de préférence recouvert par ledit élément isolant électrique et conducteur thermique 13. Le passage 17 laisse l'accès libre au deuxième ensemble E2 de composants électroniques de coupure de puissance 9 qui sont isolés électriquement mais pas thermiquement par ledit élément isolant électrique et conducteur thermique 13.

De préférence, l'appareillage de protection à coupure électronique comporte une portion conductrice de phase 28 formant d'une part au moins une première partie de la ligne de courant de phase P et d'autre part un dissipateur thermique supplémentaire 29 et étant raccordée électriquement entre la première borne de raccordement de phase 2 et la deuxième borne de raccordement de phase 3.

La portion conductrice de phase 28 formant un dissipateur thermique supplémentaire 29 peut se présenter de préférence sous la forme d'une pièce plane ou plaque plane. De préférence, la pièce plane ou plaque plane est disposée dans le boîtier 1 parallèlement aux première et deuxième faces principales et à la carte électronique 18. En outre, la pièce plane ou plaque plane est disposée en regard de la première face 19 de la carte électronique 18 sur une zone dépourvue du deuxième ensemble E2 de composant électronique de coupure de puissance 9 et en regard de la paroi séparatrice isolante 16.

La portion conductrice de phase 28 se trouve dans le prolongement de la pièce conductrice 6 de la première borne de raccordement de phase 2.

La pièce conductrice 6 de la première borne de raccordement de phase 2 et la portion conductrice de phase 28 peuvent former une pièce conductrice monobloc de phase 30.

On entend par pièce conductrice monobloc de phase 30 une pièce formée d'un seul tenant par exemple par pliage ou emboutissage par exemple d'une pièce conductrice de préférence métallique. Autrement dit, la pièce conductrice 6 de préférence en matériau conducteur électrique et la portion conductrice de phase 28 ne sont pas deux pièces distinctes et séparées, il n'existe pas de jonction par liaison mécanique entre deux pièces distinctes et qui serait formée entre la pièce conductrice 6 et la portion conductrice de phase 28.

Préférentiellement, la portion conductrice de phase 28 comporte une interface de contact 31 qui est disposée en regard de la première face 19, contre celle-ci et étant alignée avec ledit au moins un composant électronique de coupure de puissance 9 du premier ensemble E1 et est connectée électriquement et thermiquement à la carte électronique 18 sans contact électrique et thermique direct avec ledit au moins un composant électronique de coupure de puissance 9 du premier ensemble E1.

La première face 19 de la carte électronique 18 peut comprendre une couche conductrice (non représentée) de type piste ou plan équipotentiel qui est en contact direct d'une part avec l'interface de contact 31 de la portion conductrice de phase 28 et d'autre part avec ledit au moins un composant électronique de coupure de puissance 9 du premier ensemble E1. Cette couche conductrice peut être reliée à l'interface de contact 31 par un matériau de brasure.

Le premier contact fixe 23 est de préférence monté sur la carte électronique 18. Comme l'illustrent les figures 1 à 5, le premier contact fixe 23 est monté saillant sur la deuxième face 20. Le premier contact fixe 23 peut consister en une plaque métallique courbée à 90 degrés ayant une forme générale de L dont la portion la plus longue est montée de préférence par soudure ou brasure sur la deuxième face 20 et la portion la plus courte est orthogonale à la deuxième face 20.

Le deuxième contact fixe 24 fait de préférence partie de la portion conductrice de neutre 11.

Le premier contact mobile et le deuxième contact mobile peuvent être actionnés par un organe de manoeuvre de type une manette (non représenté). Cette manette est de préférence saillante de la face latérale avant.

Les figures 1 à 5 illustrent un appareillage de protection à coupure électronique phase neutre et modulaire qui présente une largeur de deux modules.. L'appareillage de protection à coupure électronique modulaire comprend le mécanisme d'isolation galvanique comprenant le premier ensemble de contacts avec le premier contact fixe 23 et le premier contact mobile disposés sur la ligne de courant de phase P en série avec les composants électroniques de coupure de puissance 9 en amont de la première borne de raccordement de phase 2 et le deuxième ensemble de contacts avec le deuxième contact fixe 24 et le deuxième contact mobile disposés sur la ligne de courant de neutre N en amont de la portion conductrice de neutre 11. La pièce conductrice 6 de la première borne de raccordement de neutre 4 et la portion conductrice de neutre 11 forment une pièce conductrice monobloc 12. La pièce conductrice 6 de la première borne de raccordement de phase 2 et la portion conductrice de phase 28 forment une pièce conductrice monobloc de phase 30. L'intérieur du boîtier 1 est divisé en deux compartiments, à savoir le compartiment de phase 14 et le compartiment de neutre 15 par la paroi séparatrice isolante 16. Le compartiment de phase 14 comprend la première borne de raccordement de phase 2 associée à la portion conductrice de phase 28, la deuxième borne de raccordement de phase 3, ladite unité de coupure électronique 8 et l'élément isolant électrique et conducteur thermique 13. Le compartiment de neutre 15 comprend la première borne de raccordement de neutre 4 associée à la portion conductrice de neutre 11 et la deuxième borne de raccordement de neutre 5. Par ailleurs, la paroi séparatrice isolante 16 comprend le passage 17 configuré pour permettre la conduction thermique de ladite unité de coupure électronique 8 vers la portion conductrice de neutre 11. L'unité de coupure électronique 8 comprend une seule carte électronique 18 avec le premier ensemble E1 comptant deux composants électroniques de coupure de puissance 9 sur ladite ligne de courant de phase P monté sur la deuxième face 20 et le deuxième ensemble E2 comptant deux composants électroniques de coupure de puissance 9 sur ladite ligne de courant de phase P monté sur la première face 19. Les deux composants électroniques de coupure de puissance 9 du deuxième ensemble E2 sont reliés électriquement en série de façon tête-bêche avec les deux composants électroniques de coupure de puissance 9 du premier ensemble E1. Les deux composants électroniques de coupure de puissance 9 du premier ensemble E1 et du deuxième ensemble E2 comprennent chacun l'élément dissipateur (non visible) sous la forme d'une plaque orientée respectivement contre la deuxième face 20 et la première face 19 et la face isolée 21 orientée à l'opposé. Le premier contact fixe 23 est monté sur la carte électronique 18 en étant saillant de la deuxième face 20. La carte électronique 18 est parallèle à la paroi séparatrice isolante 16. Les composant électronique de coupure de puissance 9 du deuxième ensemble E2 sont alignés avec le passage 17. D'autre part, l'interface de contact 22 de la portion conductrice de neutre 11 est parallèle à la paroi séparatrice isolante 16 et est alignée avec le passage 17 et avec les deux faces supérieures isolées 21 tout en étant à distance de celles-ci. L'élément isolant électrique et conducteur thermique 13 est intercalé entre les faces supérieures isolées 21 et l'interface de contact 22 et est disposé à la fois contre les faces supérieures isolées 21 et l'interface de contact 22. Les composants électroniques de coupure de puissance 9 du premier ensemble E1 sont alignés avec l'interface de contact 31. L'interface de contact 31 de la portion conductrice de phase 28 est disposée en regard de la première face 19, contre celle-ci et étant alignée avec les deux composants électroniques de coupure de puissance 9 du premier ensemble E1 et est connectée électriquement et thermiquement à la carte électronique 18 sans contact électrique et thermique direct avec les deux composants électroniques de coupure de puissance 9 du premier ensemble E1.

Dans cet exemple, l'évacuation de la chaleur provenant des composants électroniques de coupure de puissance 9 du deuxième ensemble E2 est réalisée par conduction thermique en outre dans la pièce conductrice monobloc 12 vers la première borne de raccordement de neutre 4 et l'évacuation de la chaleur provenant des composants électroniques de coupure de puissance 9 du premier ensemble E1 est réalisée en outre par conduction thermique dans la pièce conductrice monobloc de phase 30 vers la première borne de raccordement de phase 2. Une partie des calories provenant des composants électroniques de coupure de puissance 9 du deuxième ensemble E2 est également évacuée vers la deuxième borne de raccordement de neutre 5 et vers le deuxième ensemble de contacts. Une partie des calories provenant des composants électroniques de coupure de puissance 9 du premier ensemble E1 est également évacuée vers la deuxième borne de raccordement de phase 3 et vers le premier ensemble de contacts.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Appareillage de protection à coupure électronique comprenant au moins :
- un boîtier (1),
- une ligne de courant de phase (P) entre une première borne de raccordement de phase (2) et une deuxième borne de raccordement de phase (3),
- une ligne de courant de neutre (N) entre une première borne de raccordement de neutre (4) et une deuxième borne de raccordement de neutre (5),
- une unité de coupure électronique (8) comprenant au moins un composant électronique de coupure de puissance (9) disposé sur ladite ligne de courant de phase (P),
- un déclencheur électronique de protection comprenant au moins une unité de commande couplée à ladite unité de coupure électronique (8) configuré pour piloter l'ouverture dudit au moins un composant électronique de coupure de puissance (9) en cas d'apparition d'un défaut,
- au moins un dissipateur thermique (10) en matériau conducteur électrique, l'appareillage de protection à coupure électronique est **caractérisé en ce qu'**il comprend :
- une portion conductrice de neutre (11) formant d'une part au moins une première partie de la ligne de courant de neutre (N) et d'autre part dissipateur thermique (10) et étant raccordée électriquement entre la première borne de raccordement de neutre (4) et la deuxième borne de raccordement de neutre (5),
- la portion conductrice de neutre (11) étant d'une part disposée relativement à ladite unité de coupure électronique (8) de sorte à dissiper la chaleur provenant dudit au moins un composant électronique de coupure de puissance (9) associé à ladite ligne de courant de phase (P) au moins par conduction thermique et étant d'autre part isolée électriquement de ladite unité de coupure électronique (8).

2. Appareillage de protection à coupure électronique selon la revendication 1, **caractérisé en ce que** la portion conductrice de neutre (11) est isolée électriquement de ladite unité de coupure électronique (8) par un élément isolant électrique et conducteur thermique (13).

3. Appareillage de protection à coupure électronique selon l'une quelconque des revendication 1 à 2, **caractérisé en ce qu'**il comprend au moins un compartiment de phase (14) comprenant au moins la première borne de raccordement de phase (2), la deuxième borne de raccordement de phase (3) et ladite unité de coupure électronique (8), et un compartiment de neutre (15) comprenant au moins la première borne de raccordement de neutre (4) associée à la portion conductrice de neutre (11) et la deuxième borne de raccordement de neutre (5), le compartiment de phase (14) et le compartiment de neutre (15) étant séparés par une paroi séparatrice isolante (16) comprenant un passage (17) configuré pour permettre la conduction thermique de ladite unité de coupure électronique (8) vers la portion conductrice de neutre (11).

4. Appareillage de protection à coupure électronique selon l'une quelconque des revendications 1 à 3, **caractérisé en ce que** ladite unité de coupure électronique (8) comprend au moins une carte électronique (18) comprenant une première face (19) et une deuxième face (20) opposée à la première face (19) et **en ce que** ladite unité de coupure électronique (8) comprend un premier ensemble (E1) d'au moins un composant électronique de coupure de puissance (9) sur ladite ligne de courant de phase (P) monté sur la première face (19) ou la deuxième face (20) et un deuxième ensemble (E2) d'au moins un composant électronique de coupure de puissance (9) sur ladite ligne de courant de phase (P) monté sur la première face (19) ou la deuxième face (20) et relié électriquement en tête-bêche dudit au moins un composant électronique de coupure de puissance (9) du premier ensemble (E1).

5. Appareillage de protection à coupure électronique selon les revendications 3 et 4, **caractérisé en ce que** la carte électronique (18) est parallèle à la paroi séparatrice isolante (16) et ledit au moins un composant électronique de coupure de puissance (9) du deuxième ensemble (E2) est monté sur la première face (19) en regard du passage (17) et comprend un élément dissipateur orienté contre la première face (19) et une face isolée (21) orientée à l'opposé, la portion conductrice de neutre (11) comporte une interface de contact (22) qui est disposée en regard et à une distance de la face isolée (21).

6. Appareillage de protection à coupure électronique selon les revendications 2 et 5, **caractérisé en ce que** l'élément isolant électrique et conducteur thermique (13) est intercalé entre la face isolée (21) et l'interface de contact (22) et est disposé à la fois contre la face isolée (21) et l'interface de contact (22).

7. Appareillage de protection à coupure électronique selon l'une quelconque des revendications 1 à 6, **caractérisé en ce que** la première borne de raccordement de neutre (4) comprend une pièce conductrice (6) comprenant au moins une portion de contact (7) configurée pour venir au contact avec un conducteur d'alimentation du réseau ou d'une charge, la pièce conductrice (6) de la première borne de raccordement de neutre (4) est prolongée par la portion conductrice de neutre (11), la pièce conductrice (6) et la portion conductrice de neutre (11) formant une pièce conductrice monobloc (12).

8. Appareillage de protection à coupure électronique selon la revendication 7, **caractérisé en ce que** la pièce conductrice monobloc (12) est réalisée en métal et de préférence en cuivre.

9. Appareillage de protection à coupure électronique selon l'une quelconque des revendications 1 à 8, **caractérisé en ce qu'**il comprend en outre un mécanisme d'isolation galvanique comprenant un premier ensemble de contacts avec un premier contact fixe (23) et un premier contact mobile disposés sur la ligne de courant de phase (P) en série avec ladite au moins un composant électronique de coupure de puissance (9) et un deuxième ensemble de contacts avec un deuxième contact fixe (24) et un deuxième contact mobile disposés sur la ligne de courant de neutre (N) en amont ou en aval de la portion conductrice de neutre (11).

10. Appareillage de protection à coupure électronique selon l'une quelconque des revendications 1 à 9, **caractérisé en ce que** la ligne de courant de neutre (N) est dépourvue de composant électronique de coupure de puissance.

11. Appareillage de protection à coupure électronique selon l'une quelconque des revendications 1 à 10, **caractérisé en ce que** ledit au moins un composant électronique de coupure de puissance (9) comprend au moins un transistor de puissance et préférentiellement au moins un MOSFET et/ou un JFET et/ou un IGBT.
